# EUROPÄISCHE PATENTSCHRIFT

(11) **EP 0 406 484 B1**
(45) Veröffentlichungstag und Bekanntmachung des Hinweises auf die Patenterteilung: **16.06.1993**
(21) Anmeldenummer: 89122630.0
(22) Anmeldetag: 08.12.1989
(51) Int. Cl.: C23C 14/50, G02C 13/00

(54) **Linsenhalterung, insbesondere Halterung für in einer Hochvakuum-Aufdampfanlage oder -Sputteranlage zu beschichtende Brillenglaslinsen**
Mounting for lenses especially for looking glass to be coated in an apparatus for high vacuum evaparation or for sputtering
Monture pour lentilles, en particulier pour lentilles, de verre destinées au revêtement dans un appareil d'evaporation sous vide poussé ou dans un appareil pour pulvérisation cathodique

(30) Priorität: 01.07.1989 DE 3921671
(43) Veröffentlichungstag der Anmeldung: 09.01.1991
(73) Patentinhaber: LEYBOLD AKTIENGESELLSCHAFT, D-63450 Hanau (DE)
(72) Erfinder: Kunkel, Georg, D-8751 Heigenbrücken (DE); Klingenstein, Dieter, D-6455 Erlensee (DE); Mahr, Heinz, D-6470 Büdingen 2 (DE); Fliedner, Michael, D-6454 Bruchköbel (DE)

(56) Entgegenhaltungen:
- DE-A- 3 715 831
- US-A- 4 592 308

## Beschreibung

Die Erfindung betrifft einen Linsenhalter für eine in der Prozeßkammer einer Hochvakuum-Aufdampf oder -Sputteranlage in der Nachbarschaft der Beschichtungsquelle angeordnete, aus einem kalottenförmig ausgeformten Blechzuschnitt gebildeten Substrathalterung und mit einem ersten, von der Substrathalterung getragenen Ring und einem zweiten, mit dem ersten Ring verbindbaren Ring, wobei die Linse zwischen die beiden Ringe einlegbar ist.

Bekannt ist eine Vakuum-Beschichtungsanlage zum Aufdampfen von Vergütungsschichten auf optische Substrate (DE-OS 37 15 831), wie Kunststoff-Brillengläser, welche auf Trägermittel aufspannbar sind, die in einem evakuierbaren Rezipienten oberhalb von Verdampfungsquellen umlaufen, wobei die Trägermittel eine Mehrzahl wenigstens angenähert kreissegmentförmige, flächige Trägerplatten umfassen, welche zueinander kalottenförmig sowie je um 180° wendbar an einer gemeinsamen Drehachse abgestützt sind, wobei jede Trägerplatte in Öffnungsbereichen eine Mehrzahl mit mindestens einer Haltefeder versehene Substrathalterungen aufweist, von denen mindestens eine nach beiden Seiten aus der Trägerplattenebene bis zu einem vorgegebenen Winkel heraus frei kippbar ist.

Jede frei kippbare Substrathalterung weist dabei eine das aufzunehmende Substrat teilweise umgreifende Fassung auf, in welcher das Substrat unter der Wirkung der Haltefeder steht und welche frei nach beiden Seiten hin kippbar über eine Kippachse an der Trägerplatte befestigt ist.

Weiterhin ist eine Linsenhalterung, insbesondere Halterung für zu reinigende und nachfolgend zu beschichtende Brillenglaslinsen bekannt (EP-A-0 215 261), welche als ein an seiner Innenseite Gabeln zur Aufnahme der zu haltenden Linsen tragender Ring ausgebildet ist, wobei der Ring elastisch verformbar ist und die Gabein an zwei einander gegenüberliegenden Abschnitten der Ringinnenseite angeordnet sind.

Der vorliegenden Erfindung liegt nun die Aufgabe zugrunde, eine Linsenhalterung zu schaffen, die einen besonders raschen Austausch von Linsen erlaubt, die die Linsen in einem besonders schmalen Bereich über ihre Außenkanten sicher hält und die ein rasches Wenden der Linse gegenüber der Beschichtungsquelle erlaubt, wobei die jeweils der Quelle zugekehrte eine Außenfläche der Linse den gleichen Abstand zur Quelle haben soll wie die jeweils andere Außenfläche der Linse nach dem Wenden.

Erfindungsgemäß wird diese Aufgabe dadurch gelöst, daß die beiden Ringe über federnde Zungen oder Arme gegeneinander verspannbar sind, wozu der erste Ring an seiner äußeren Mantelfläche mit Nocken oder Rampen mit sich in axialer Richtung erstreckenden Lappen versehen ist, die an ihrer Innenseite Nuten aufweisen, wobei die Nocken, Rampen bzw. die Lappen mit den federnden Zungen oder Armen zusammenwirken, die an der radial äußeren Mantelfläche des zweiten Rings angeordnet sind.

Vorzugsweise ist zumindest einer der beiden Ringe an seiner radial inneren Mantelfläche mit einer umlaufenden Nut, einer Fase oder mit sich radial nach innen zu erstreckenden Vorsprüngen versehen, auf der der äußere Rand der Linse abgestützt ist.

Um ein rasches Wenden des Ringpaares zu ermöglichen, weist zumindest einer der Ringe an seiner radial äußeren Mantelfläche zwei sich diametral gegenüberliegende Zapfen oder Finger auf, die jeweils in einem korrespondierenden Lager oder einer Lagergabel an den Substratträger gelagert sind.

Damit ein sicheres Verklippen der Ringe miteinander ermöglicht wird, ist der eine der beiden Ringe an seiner radial äußeren Mantelfläche mit mindestens zwei einander diametral gegenüberliegenden Nuten versehen, deren Längserstreckungen in einem Winkel von etwa 30° zur Rotationsachse des Rings verlaufen, wobei federnde Zungen aus Drahtenden vorgesehen sind, deren jeweils eines Ende mit dem Ring fest verlötet, verschweißt oder vernietet ist und deren jeweils anderes Ende zu einer Bucht oder Schlinge gebogen ist, die sich in einer Ebene erstreckt, die parallel der Ebene der mit dieser zusammenwirkenden Nut verläuft.

Mit Vorteil weist zumindest einer der Zapfen einen sich quer zum Zapfen erstreckenden Nocken oder Finger auf, in dessen unmittelbarer Nachbarschaft ein Paar Magneten auf dem Substratträger angeordnet sind, sodaß der Ring bzw. das Ringpaar nur zwei gegenüber unerwünschten Drehbzw. Wendebewegungen stabile Lagen bzw. Positionen einnimmt.

Weitere Einzelheiten und Merkmale sind in den Unteransprüchen gekennzeichnet.
Die Erfindung läßt die verschiedensten Ausführungsmöglichkeiten zu. Eine davon ist in den anhängenden Zeichnungen schematisch näher dargestellt, und zwar zeigen:
- Fig. 1: eine Hochvakuum-Aufdampfanlage, teilweise im Schnitt,
- Fig. 2: den kalottenförmig gebogenen Substratträger gemäß Figur 1 im vergrößerten Maßstab,
- Fig. 3 und 4: die beiden Ringe zur Halterung der Brillenglaslinse in perspektivischer Darstellung,
- Fig. 5: die beiden miteinander verbundenen Ringe gemäß den Figuren 3 und 4 und deren Lagerung auf dem Substratträger in der Seitenansicht,
- Fig. 6: den Teillängsschnitt durch die beiden Ringe mit eingelegter Brillenglaslinse und
- Fig. 7 und 8: eine alternative Ausführungsform der beiden Ringe zur Halterung der Brillenglaslinse in perspektivischer Darstellung.

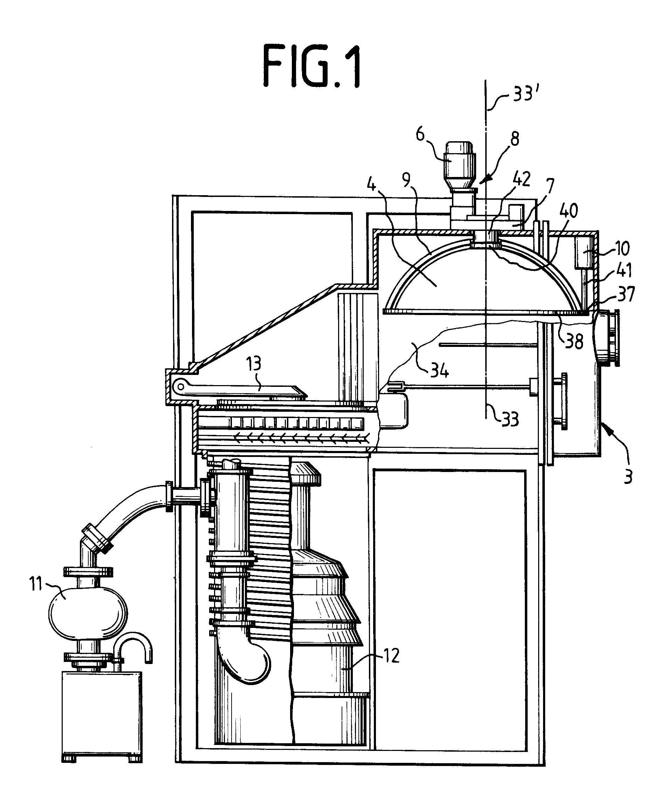

Die in Figur 1 dargestellte Hochvakuum-Aufdampfanlage besteht im wesentlichen aus einem Rezipienten 3 mit einer in diesem angeordneten, jedoch nicht näher dargestellten Verdampferquelle, einer kalottenförmig gebogenen Substrathalterung 4 aus einem mit einer Vielzahl von Öffnungen 5, 5', ... versehenen Blechzuschnitt, aus einer aus einem Motor 6 mit Getriebe 7 bestehenden Antriebseinheit 8, einem um eine vertikale Achse drehbaren, oberhalb der Substrathalterung 4 gelagerten Schieber oder Rechen 9 mit Hubmotor 10, einem Vorpumpsatz 11, einer Diffusionspumpe 12 und einem Vakuumventil 13.

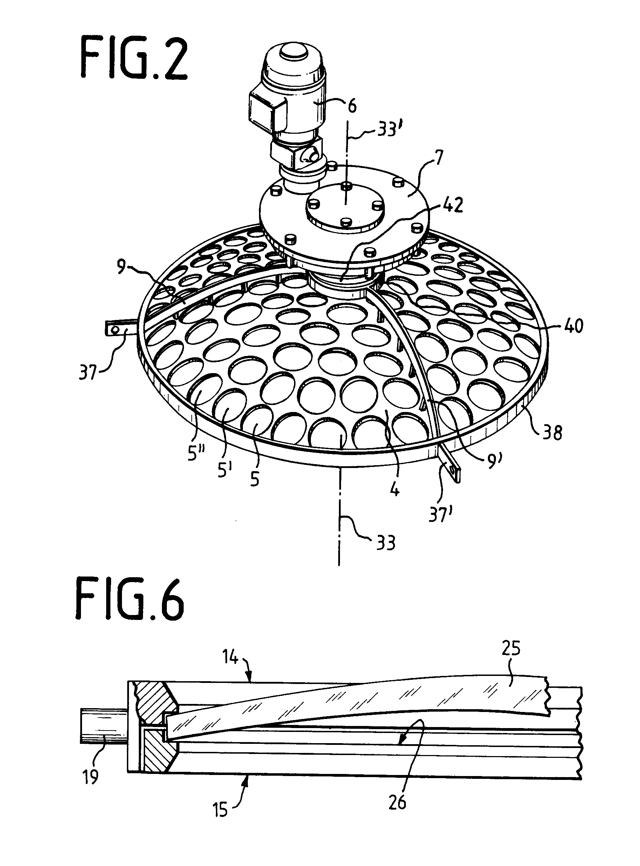

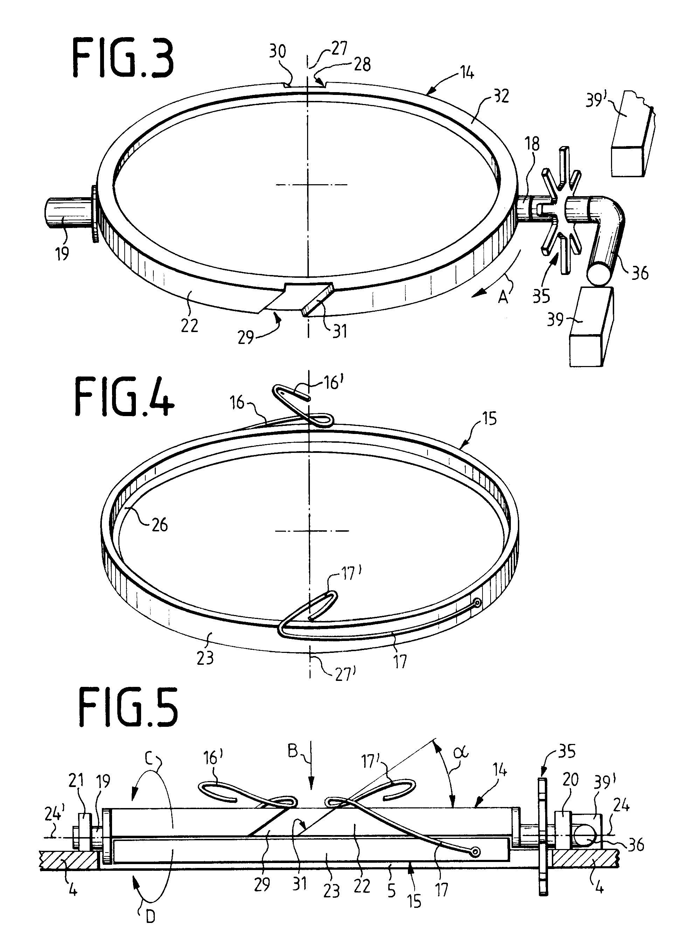

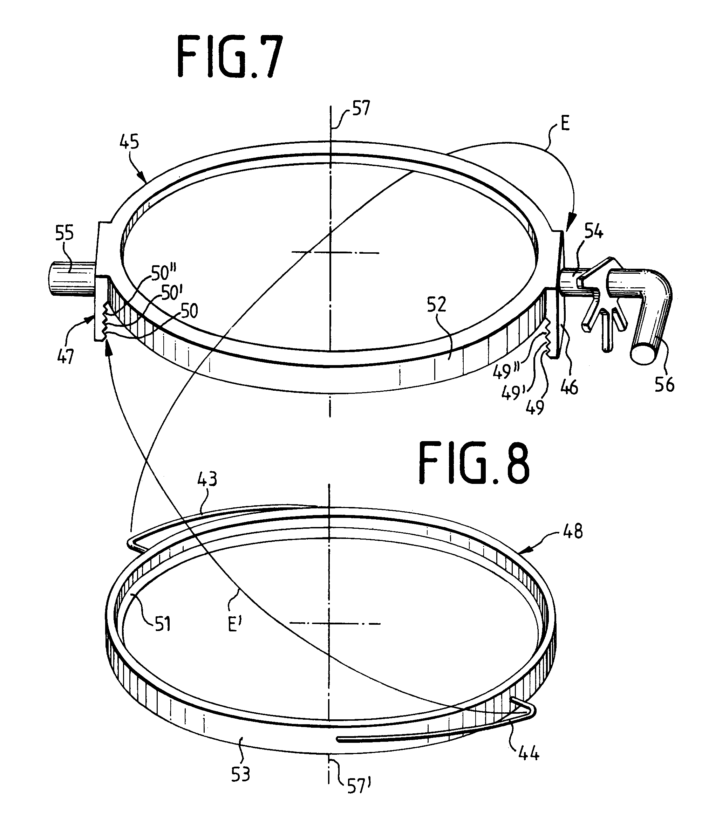

Die aus Figur 2 ersichtlichen Öffnungen 5, 5', ... in der Substrathalterung (die nur bei einem Abschnitt der Substrathalterung dargestellt sind) dienen der Aufnahme von Ringpaaren 14, 15, die mit Hilfe von Drahtfedern 16, 17 miteinander verbunden sind und über Zapfen 18, 19 in Lagergabeln 20, 21 einsetzbar sind, die sich jeweils paarweise in den Randbereichen der Öffnungen 5, 5', ... der Substrathalterung 4 befinden (in Figur 2 jedoch der besseren Übersichtlichkeit wegen nicht näher eingezeichnet sind). Gemäß den Figuren 3 und 5 ist der erste der beiden Ringe 15 an seiner radial äußeren Mantelfläche 22 mit den beiden einander diametral gegenüberliegenden Zapfen 18, 19 versehen, wobei die Längsachse 24, 24' bzw. die Rotationsachse der beiden Ringe etwa in der Berührungsebene dieser beiden Ringe 14, 15 verläuft.

Um die Brillenglaslinse 25 in die Ringe 14, 15 einlegen und diese anschließend miteinander verbinden zu können, wird die Brillenglaslinse 25 in einem ersten Arbeitsschritt auf die entsprechend bemessene Fase bzw. flanschförmige Stufe 26 des zweiten Rings 15 aufgelegt, dann wird in einem zweiten Arbeitsschritt der erste Ring 15 von oben her auf den zweiten Ring 15 so aufgelegt, daß die Rotationsachsen 27, 27' der beiden Ringe 14, 15 fluchten bzw. zusammenfallen; in einem dritten Arbeitsschritt wird der erste Ring 14 gegenüber dem zweiten Ring 15 in Pfeilrichtung A (Figur 3) gedreht, und zwar so lange, bis die buchtenförmigen, federnden Enden 16', 17' der Drahtfedern 16, 17 in die beiden Nuten 28, 29 hineingleiten, die in die radial äußere Mantelfläche 22 des ersten Rings 14 einander diametral gegenüberliegend eingeschnitten sind. Die buchtenförmigen Enden 16', 17' rutschen bei dieser Drehbewegung die Rampen 30, 31 der Nuten 28, 29 entlang, bis sie auf der Oberseite 32 des ersten Rings 14 aufliegen und so beide Ringe 14, 15 mit der dazwischenliegenden Brillenglaslinse 25 zusammenhalten (siehe Figur 5).

Die beiden miteinander verklippten Ringe 14, 15 werden nun mit ihren Zapfen 18, 19 in Pfeilrichtung B in die beiden gabelförmigen bzw. U-förmigen Lagergabeln 20, 21 eingelegt, die sich paarweise jeweils an jeder Öffnung 5, 5', ... der Substrathalterung 4 befinden. Der Außendurchmesser der beiden Ringe 14, 15 bzw. der Innendurchmesser der Öffnungen 5, 5', ... ist dabei so bemessen, daß sich die beiden miteinander verklippten Ringe 14, 15, die zusammen ein Ringpaar bilden, in Pfeilrichtung C oder D um die Längsachse 24, 24' drehen lassen (Pfeilrichtung C, D in Figur 5). Diese Dreh- oder Schwenkbewegung ist mit Hilfe eines im Rezipienten 3 gelagerten Rechen 9 bei geschlossener Prozeßkammer 34 durchführbar. Der Rechen 9, der als halbkreisförmiger Blechzuschnitt ausgebildet ist und bei einer Drehbewegung der Substrathalterung 4 um die Achse 33, 33' nach Art eines Kamms über die Oberseite der Substrathalterung 4 streicht, gerät dabei in Kontakt mit Zähnen eines auf jeweils einem Zapfen 18 des ersten Rings 14 drehfest angeordneten Zahnrads 35 und nimmt dieses so lange mit, bis das Ringpaar 14, 15 eine 180° Schwenkbewegung um die Längsachse 24, 24' vollführt hat. Ein am Zapfen 18 vorgesehener Finger 36 legt sich dabei auf die Oberseite der Substrathalterung 4 auf und verhindert eine weitere Drehbewegung bzw. wird in dieser Position von einem der Magnete 39, 39' gehalten, die in der Ebene des Fingers 36 im Abstand zueinander auf der Oberseite der Substrathalterung 4 fest angeordnet sind. Die beiden Magnete 39, 39' tragen dafür Sorge, daß das Ringpaar 14, 15 während des Wendevorgangs nicht in einer Zwischenposition bzw. in einer instabilen Position stehen bleibt oder nach dem Wendevorgang in diese zurückschwingt. Der in die Zahnräder 35 der jeweiligen Ringpaare 14, 15 eingreifende Rechen 9 ermöglicht also eine Schwenkbewegung der Ringpaare bzw. der in diese eingelegten Brillenglaslinsen 25 während des laufenden Beschichtungsvorgangs, d. h. bei geschlossenem Rezipienten 3, wozu ein besonderer Hubmotor 10 mit Hubglied 41 und Gelenk 37 vorgesehen ist, der dazu an einen Koppelring 38 angelenkt ist, der mehrere Rechen 9, 9' miteinander verbindet, wobei die Rechen 9, 9' über einen Hubring 40 miteinander verbunden sind, der auf dem Lagerrohr 42 der Antriebseinheit 8 verschiebbar gehalten und geführt ist.

Bei der Ausführungsform der beiden Ringe 45, 48 nach den Figuren 7 und 8 sind statt der Auflauframpen 30, 31 oder Nuten 28, 29 zwei Lappen 46, 47 am ersten Ring 45 befestigt, die sich parallel zur Rotationsachse 57, 57' nach unten zu, d. h. in Richtung auf den zweiten Ring 48 zu, erstrecken und die jeweils an den einander zugekehrten Innenflächen mit Nuten 49, 49', ... bzw. 50, 50', oder Ausnehmungen versehen sind, die mit federnden Zungen 43 bzw. 44 zusammenwirken, die an der radial äußeren Mantelfläche 53 des zweiten Rings 48 befestigt sind. Nach dem Einlegen der Brillenglaslinse in den zweiten Ring 48 bzw. auf die flanschförmige Stufe 51 kann der zweite Ring 48 in Pfeilrichtung E, E' in die Nuten 49 bzw. 50 eingedreht werden, wobei je nach der Dicke der Brillenglaslinse jeweils eine der unteren oder eine der oberen Nuten benutzt wird.

### Auflistung der Einzelteile

- 3: Rezipient
- 4: Substrathalterung
- 5, 5', ..: Öffnung
- 6: Motor
- 7: Getriebe
- 8: Antriebseinheit
- 9, 9': Rechen
- 10: Antriebsmotor
- 11: Vorpumpsatz
- 12: Diffusionspumpe
- 13: Vakuumventil
- 14: erster Ring
- 15: zweiter Ring
- 16, 16': Drahtfeder, federnde Zunge
- 17, 17': Drahtfeder, federnde Zunge
- 18: Zapfen
- 19: Zapfen
- 20: Lagergabel
- 21: Lagergabel
- 22: radial äußere Mantelfläche
- 23: radial äußere Mantelfläche
- 24, 24': Längsachse
- 25: Brillenglaslinse
- 26: flanschförmige Stufe
- 27, 27': Rotationsachse
- 28: Nut
- 29: Nut
- 30: Rampe
- 31: Rampe 31 Rampe
- 32: Ringoberseite
- 33: Drehachse
- 34: Prozeßkammer
- 35: Zahnrad
- 36: Finger
- 37: Gelenk
- 38: Koppelring
- 39, 39': Magnet
- 40: Hubring
- 41: Hubglied
- 42: Lagerrohr
- 43: Drahtfeder, federnde Zunge
- 44: Drahtfeder, federnde Zunge
- 45: erster Ring
- 46: Lappen
- 47: Lappen
- 48: zweiter Ring
- 49, 49', ...: Nut
- 50, 50', ...: Nut
- 51: flanschförmige Stufe
- 52: radial äußere Mantelfläche
- 53: radial äußere Mantelfläche
- 54: Zapfen
- 55: Zapfen
- 56: Finger
- 57, 57': Rotationsachse

## Patentansprüche

1. Linsenhalter für eine in der Prozeßkammer einer Hochvakuum-Aufdampf oder -Sputteranlage in der Nachbarschaft der Beschichtungsquelle angeordnete, aus einem kalottenförmig ausgeformten Blechzuschnitt gebildeten Substrathalterung und mit einem ersten, von der Substrathalterung getragenen Ring (14) und einem zweiten, mit dem ersten Ring (14) verbindbaren Ring (15), wobei die Linse (25) zwischen die beiden Ringe (14, 15) einlegbar ist und die beiden Ringe (14, 15) über federnde Zungen oder Arme (16, 17 bzw. 43, 44) gegeneinander verspannbar sind, wozu der erste Ring (14 bzw. 45) an seiner äußeren Mantelfläche (22 bzw. 52) mit Nocken, Rampen (30, 31) oder mit sich in axialer Richtung erstreckenden Lappen (46, 47) versehen ist, die an ihrer Innenseite Nuten (49, 49', ... 50, 50', ...) aufweisen, wobei die Nocken, Rampen bzw. die Lappen mit den federnden Zungen oder Armen (16, 17 bzw. 43, 44) zusammenwirken, die an der radial äußeren Mantelfläche (23 bzw. 53) des zweiten Rings (15 bzw. 48) angeordnet sind.

2. Linsenhalterung nach Anspruch 1, **dadurch gekennzeichnet,** daß zumindest einer der beiden Ringe (14, 15 bzw. 45, 48) an seiner radial inneren Mantelfläche eine umlaufende Fase, eine flanschförmige Stufe (26 bzw. 51) oder sich radial nach innen zu ertreckende Vorsprünge aufweist, auf der der äußere Rand der Linse (25) abstützbar ist.

3. Linsenhalterung nach den Ansprüchen 1 und 2, **dadurch gekennzeichnet,** daß zumindest einer der Ringe (14 bzw. 45) an seiner radial äußeren Mantelfläche (22) zwei sich diametral gegenüberliegende Zapfen (18, 19 bzw. 54, 55) oder Finger aufweist, die jeweils in einem korrespondierenden Lager oder einer Lagergabel (20, 21) an der Substrathalterung (4) gelagert sind.

4. Linsenhalterung nach den Ansprüchen 1 bis 3, **dadurch gekennzeichnet,** daß der eine der beiden Ringe (14) an seiner äußeren Mantelfläche (22) mit mindestens zwei einander diametral gegenüberliegenden Nuten (28, 29) versehen ist, deren Längserstreckungen in einem Winkel α von etwa 30° zur Rotationsachse (27, 27') des Rings (14) verlaufen.

5. Linsenhalterung nach einem oder mehreren der vorhergehenden Ansprüchen, **dadurch gekennzeichnet,** daß die federnden Zungen als Drahtfedern (16, 17) ausgebildet sind, deren jeweils eines Ende mit dem Ring (15) fest verlötet, verschweißt oder vernietet ist und deren jeweils anderes Ende zu einer Bucht (16', 17') oder Schlinge gebogen ist, die sich in einer Ebene erstreckt, die parallel der Ebene der mit dieser zusammenwirkenden Nut (28, 29) oder Rampe (30, 31) verläuft.

6. Linsenhalterung nach einem oder mehreren der vorhergehenden Ansprüche, **dadurch gekennzeichnet,** daß zumindest einer der Zapfen (18 bzw. 54) einen, sich quer zum Zapfen erstreckenden Nocken oder Finger (36 bzw. 56) aufweist, in dessen unmittelbarer Nachbarschaft ein Paar Magnete (39, 39') auf dem Substratträger angeordnet sind, so daß der Ring (14) nur zwei gegenüber unerwünschten Drehbewegungen stabile Lagen einnimmt.

7. Linsenhalterung nach den Ansprüchen 1 bis 3, **dadurch gekennzeichnet,** daß die federnden Zungen (43, 44) als Drahtfedern ausgebildet sind, deren jeweils beide Enden mit dem Ring (53) fest verlötet, verschweißt oder vernietet sind, wobei die Zungen bzw. Drahtfedern (43, 44) sich in Ebenen erstrecken, die zur Ebene des Rings (53) geneigt verlaufen.

8. Linsenhalterung nach einem oder mehreren der vorhergehenden Ansprüche, **dadurch gekennzeichnet,** daß die beiden Lappen (46, 47) des ersten Rings (45) eine Vielzahl von Nuten (49, 49', ...; 50, 50', ...) aufweisen, die in zur Ebene des Rings (45) parallelen Ebenen an den einander zugekehrten Innenflächen der Lappen (46, 47) vorgesehen sind, wobei die beiden Lappen (46, 47) einander diametral gegenüberliegend im Bereich der Zapfen (54, 55) angeordnet sind bzw. einstückig mit diesen ausgebildet sind.

9. Linsenhalterung nach Anspruch 8, **dadurch gekennzeichnet,** daß der Abstand, den die radial äußeren Partien der beiden Drahtfedern (43, 44) voneinander aufweisen, etwa dem Abstand, den zwei mit diesen Drahtfedern (43, 44) korrespondierenden, einander gegenüberliegenden Nuten (49, 50 bzw. 49', 50', ...) voneinander aufweisen, entspricht.

## Claims

1. Lens support for a substrate support formed of a lune-shaped sheet-metal blank mounted in the processing chamber of a high-vacuum metallising or cathode sputtering installation in the vicinity of the coating source, having a first ring (14) held by the substrate support and a second ring (15) connectable to the first ring (14), the lens (25) being insertable between the two rings (14, 15) and the two rings (14, 15) being braced together via resilient tongues or arms (16, 17 and 43, 44 respectively), to which end the first ring (14 and 45 respectively) is provided on its outer surface (22 and 52 respectively) with cams, slopes (30, 31) or tabs (46, 47) extending in the axial direction and having on their inner side grooves (49, 49',..., 50, 50',...), the cams, slopes or tabs cooperating with the tongues or arms (16, 17 and 43, 44 respectively), which are mounted on the radially outer surface (23 and 53 respectively) of the second ring (15 and 48 respectively).

2. Lens support according to claim 1, characterised in that at least one of the two rings (14, 15 and 45, 48 respectively) has on its radially inner surface a continuous chamfer, a flange-shaped step (26 and 51 respectively) or projections extending radially inward, on which the outer edge of the lens (25) can be supported.

3. Lens support according to claims 1 and 2, characterised in that at least one of the rings (14 and 45 respectively) has on its radially outer surface (22) two diametrically opposite lugs (18, 19 and 54, 55 respectively) or fingers, which are each mounted in a corresponding bearing or bearing fork (20, 21) on the substrate support (4).

4. Lens support according to claims 1 to 3, characterised in that one of the two rings (14) has on its outer surface (22) at least two diametrically opposite grooves (28, 29), whose longitudinal extensions are at an angle α of 30° to the axis of rotation (27, 27') of the ring (14).

5. Lens support according to one or more of the preceding claims, characterised in that the resilient tongues are formed as wire springs (16, 17), one end of which in each case is firmly soldered, welded or riveted to the ring (15) and the other end of which is curved into a bow (16', 17') or loop extending in a plane which runs parallel to the plane of the groove (28, 29) or slope (30, 31) cooperating therewith.

6. Lens support according to one or more of the preceding claims, characterised in that at least one of the lugs (18 and 54 respectively) has a cam or finger (36 and 56 respectively), which extends transverse to the lug and in whose immediate vicinity a pair of magnets (39, 39') are mounted on the substrate support, so that the ring (14) only assumes two positions which are secure against undesirable rotation.

7. Lens support according to claims 1 to 3, characterised in that the resilient tongues (43, 44) are formed as wire springs whose two ends in each case are firmly soldered, welded or riveted to the ring (53), the tongues or wire springs (43, 44) extending in planes which are inclined relative to the plane of the ring (53).

8. Lens support according to one or more of the preceding claims, characterised in that the two tabs (46, 47) of the first ring (45) have a plurality of grooves (49, 49',...; 50, 50',...) provided in planes parallel to the plane of the ring (45) on the mutually facing inner faces of the tabs (46, 47), the two tabs (46, 47) being located diametrically opposite one another in the region of the lugs (54, 55) or being formed integrally with said lugs.

9. Lens support according to claim 8, characterised in that the distance between the radially outer parts of the two wire springs (43, 44) is approximately the same as the distance between the two mutually opposite grooves (49, 50 and 49', 50' ... respectively) corresponding to the wire springs (43, 44).

## Revendications

1. Porte-lentille pour un porte-substrats disposé dans la chambre de processus d'une installation de dépôt par vaporisation sous vide élevé ou une installation de crépitement sous vide élevé, au voisinage de la source de revêtement, et constitué d'une pièce de tôle mise en forme de calotte, porte-lentille comportant un premier anneau (14), porté par le porte-substrats et un second anneau (15) qui peut être relié au premier anneau (14), porte-lentille dans lequel la lentille (25) peut s'insérer entre les deux anneaux (14, 15) et dans lequel les deux anneaux (14, 15) peuvent être bridés l'un contre l'autre au moyen de lames ou bras élastiques (16, 17 ou 43, 44), ce pour quoi le premier anneau (14 ou 15) comporte, à sa surface latérale extérieure (22 ou 52) des cames, rampes (30, 31) ou des oreilles qui s'étendent selon la direction axiale et présentent sur leur face intérieure des rainures (49, 49', ..., 50, 50', ...), porte-lentille dans lequel les cames, rampes ou les oreilles collaborent avec les lames élastiques ou bras (16, 17 ou 43, 44) qui sont diposés à la surface latérale radialement extérieure (23 ou 53) du second anneau (15 ou 48).

2. Porte-lentille selon la revendication 1, caractérisé par le fait qu'au moins l'un des deux anneaux (14, 15 ou 45, 48) présente, à sa surface latérale radialement intérieure, un chanfrein périphérique, un échelon en forme de collet (26 ou 51) ou des saillies qui doivent s'étendent radialement vers l'intérieur, ce sur quoi peut s'appuyer le bord extérieur de la lentille (25).

3. Porte-lentille selon les revendications 1 et 2, caractérisé par le fait qu'au moins l'un des anneaux (14 ou 45) présente, à sa surface latérale radialement extérieure (22), deux tourillons (18, 19 ou 54, 55), ou doigts, qui sont situés diamétralement en face l'un de l'autre et sont, chacun, portés dans une portée correspondante ou une chape (20, 21) prévue sur le porte-substrats (4).

4. Porte-lentille selon les revendications 1 à 3, caractérisé par le fait que l'un (14) des deux anneaux présente, sur sa surface latérale extérieure (22), au moins deux encoches (28, 29) qui sont situées diamétralement en face l'une de l'autre et dont les extensions longitudinales font un angle α d'environ 30° par rapport à l'axe de rotation (27, 27') de l'anneau (14).

5. Porte-lentille selon une ou plusieurs des revendications précédentes, caractérisé par le fait que les lames élastiques sont conçues sous forme de ressorts en fil métallique (16, 17) dont l'une des extrémités de chacun est brasée, soudée ou rivée fixement avec l'anneau (15) et dont l'autre extrémité de chacun est cintrée pour donner une anse (16', 17') ou une boucle qui s'étend dans un plan parallèle au plan de l'encoche (28, 29) ou de la rampe (30, 31) qui collabore avec cette anse ou cette boucle.

6. Porte-lentille selon une ou plusieurs des revendications précédentes, caractérisée par le fait qu'au moins l'un des tourillons (18 ou 54) présente un ergot ou un doigt (36 ou 56) qui s'étend transversalement par rapport au tourillon et au voisinage immédiat duquel une paire d'aimants (39, 39') sont disposés sur le porte-substrats de façon que l'anneau (14) ne prenne que deux positions stables à l'égard de mouvements de rotation non désirés.

7. Porte-lentille selon l'une des revendications 1 à 3, caractérisé par le fait que les lames élastiques (43, 44) sont conçues sous forme de ressorts en fil métallique dont les deux extrémités de chacun sont brasées, soudées ou rivées fixement avec l'anneau (53), étant précisé que les lames ou ressorts en fil métallique (43, 44) s'étendent dans des plans qui sont inclinés par rapport au plan de l'anneau (53).

8. Porte-lentille selon l'une ou plusieurs des revendications précédentes, caractérisé par le fait que les deux oreilles (46, 47) du premier anneau (45) présentent une pluralité de rainures (49, 49',...; 50, 50',...) qui sont prévues, dans des plans parallèles au plan de l'anneau (45), sur les surfaces intérieures, orientées l'une vers l'autre, des oreilles (46, 47), étant précisé que les deux oreilles (46, 47) sont disposées diamétralement opposées l'une à l'autre dans la zone des tourillons (54, 55) et sont conçues d'une pièce avec ceux-ci.

9. Porte-lentille selon la revendication 8, caractérisé par le fait que la distance à laquelle sont les parties, radialement extérieures, des deux ressorts en fil métallique (43, 44) correspond à peu près à la distance à laquelle sont l'une de l'autre deux rainures (49, 50 ou 49', 50',...) situées en face l'une de l'autre et correspondant avec ses ressorts en fil métallique (43, 44).
